# EUROPÄISCHE PATENTSCHRIFT

(11) **EP 2 757 354 B1**
(45) Veröffentlichungstag und Bekanntmachung des Hinweises auf die Patenterteilung: **30.09.2015**
(21) Anmeldenummer: 13152156.9
(22) Anmeldetag: 22.01.2013
(51) Int. Cl.: G01G 3/14, G01G 23/00

(54) **Detektion elektrostatischer Kräfte**
Detection of electrostatic forces
Détection de forces électrostatiques

(43) Veröffentlichungstag der Anmeldung: 23.07.2014
(73) Patentinhaber: Mettler-Toledo AG, 8606 Greifensee (CH)
(72) Erfinder: Bühler, Stefan, 8606 Nänikon (CH)

(56) Entgegenhaltungen:
- EP-A1- 1 813 920
- EP-A2- 1 106 978
- DE-U1- 9 006 837
- US-A- 5 332 870

## Beschreibung

Die Erfindung betrifft ein Verfahren zur Abschätzung des Einflusses von elektrostatischen Ladungen des Wägeguts auf das Wägeergebnis einer Waage sowie eine Waage zur Durchführung des Verfahrens.

Beim präzisen Verwiegen von Wägegütern ist es ein Erfordernis, möglichst sämtliche Einflussfaktoren auf die Genauigkeit des Wägeresultats zu minimieren. Beispielhaft seien hier Luftbewegungen genannt, welche meist mittels eines Windschutzes auf ein vernachlässigbares Mass reduziert werden können, oder Schwankungen der Umgebungsbedingungen, wie Temperatur oder Feuchtigkeit, die beispielsweise durch das Platzieren der Waage in einem klimatisierten Raum beseitigt werden können.

Ein weiterer, das Wägeergebnis beeinflussender Faktor umfasst das Vorhandensein elektrostatischer Ladungen im Wägeraum, beziehungsweise in der Umgebung oder direkt auf der zu wiegenden Last, die insbesondere beim Verwiegen von nicht leitfähigen Proben oder beim Verwiegen von Proben, die sich in Gefässen aus nicht-leitfähigem Material befinden, zum Tragen kommen. Besonders problematisch ist die Wirkung elektrostatischer Aufladungen bei Verwendung grosser Glas- oder Polymergefässe im Falle der Bestimmung kleiner Massendifferenzen als Wägeaufgabe. Eine elektrostatische Aufladung des Lastaufnehmers selbst, auf welchem die betreffenden Proben und/oder Gefässe, also die Last, platziert sind, findet meist nicht statt, da dieser in der Regel aus Metall gefertigt ist und die Ladungen über eine leitfähige Verbindung mit dem geerdeten Waagengehäuse abfliessen können.

Eine elektrostatische Aufladung einer auf dem Lastaufnehmer befindlichen Last bewirkt eine Potentialdifferenz zwischen der Last und den geerdeten Waagenteilen. Aufgrund dieser Potentialdifferenz wirkt eine Kraft zwischen der Last und beispielsweise dem Wägeraumboden. Damit wirkt die Vertikalkomponente dieser Kraft auch auf die Wägezelle und addiert sich zu der durch die Last erzeugten Gewichtskraft. Demzufolge wird ein falsches Wägeresultat erzeugt und angezeigt. Beispielsweise beim Wiegen einer Probe in einer Kunststoffschale können elektrostatische Ladungen einen Messfehler von ca. 2mg verursachen. Bei einer ca. 20mg schweren Probe kann dadurch der Messfehler ca. 10% des Probengewichts betragen.

Weitere Waagenteile, wie beispielsweise ein vorhandener Windschutz oder andere Bereiche des Gehäuses können, sofern sie aus nicht-leitfähigem Material bestehen, sich ebenfalls elektrostatisch aufladen und durch einen so genannten Kraftnebenschluss verfälschend auf das Wägeresultat wirken.

Eine Analysenwaage zur Wägung von elektrostatisch aufgeladenem Wägegut beschreibt die EP 1 106 978 A1. Die mit einem Windschutz versehene Waage weist eine Vorrichtung zur Erzeugung eines ionisierten Luftstroms auf. Diese Vorrichtung umfasst eine Ionisationsvorrichtung mit mindestens zwei Spitzenelektroden, die Spannungen verschiedenen Vorzeichens gegenüber der jeweiligen Gegenelektrode aufweisen, sowie einen Ventilator. Die Vorrichtung kann beim Schliessen der Windschutzöffnungen aktiviert werden und nach einer vorgegebenen Laufzeit ausgeschaltet werden.

Nachteilig bei der beschriebenen Vorrichtung ist, dass einerseits der Ventilator unerwünschte Luftströmungen im Bereich des Lastaufnehmers erzeugen kann und andererseits, dass stets ein fest vorgegebenes Mass an Ionisationsladungen zur Neutralisierung der Aufladungen zur Verfügung steht, unabhängig vom Aufladungsgrad der Last auf dem Lastaufnehmer.

Eine Waage mit einem Elektrostatiksensor zum Ermitteln des Vorhandenseins elektrostatischer Aufladungen und zum Zuleiten der Information bezüglich des das Mass der Aufladungen kennzeichnenden Werts ist in der EP 1 813 920 A1 offenbart. Die Waage mit einem Lastaufnehmer zur Aufnahme einer zu wiegenden Last, und mit einer Wägeelektronik, die eine Messeinheit aufweist, ist mit einem Elektrostatiksensor versehen, welcher derart angeordnet ist, dass elektrostatische Aufladungen an einer auf dem Lastaufnehmer aufgebrachten oder aufzubringenden Last detektierbar sind. Die elektrostatischen Ladungen sind zwar kontinuierlich aber nicht gleichmässig im Raum verteilt. Ihre Konzentration und ihre Polarität sind bei jedem Material verschieden. Das heisst, dass in der EP 1 813 920 A1 überwiegend Ladungen in der Nähe des Elektrostatiksensors detektiert werden. Das Messergebnis des Elektrostatiksensors hängt davon ab, wo in der Waage er sich befindet. Daher ist die Messung elektrostatischer Ladungen mit einem Elektrostatiksensor nur begrenzt aussagekräftig.

Ein weiterer Nachteil liegt daran, dass der Elektrostatiksensor den Umfang der elektrostatischen Ladungen unabhängig von der Richtung in die sie wirken misst. Erstens haben nur die Vertikalkomponenten der Anziehungskräfte einen Einfluss auf das Wägeergebnis, zweitens ist die Richtung der vertikalen Anziehungskräfte auch relevant, je nachdem ob sie das Wägegut nach unten oder nach oben ziehen. Deshalb ist die Messung der gesamten Ladungen, die sich in der Nähe des Elektrostatiksensors befinden, nicht bedeutsam.

Ausserdem erfordert diese Waage den Gebrauch eines zusätzlichen Sensors zur Wägezelle.

Daher liegt der vorliegenden Erfindung die Aufgabe zugrunde, ein Verfahren und eine Vorrichtung anzugeben, die es ermöglichen, den Einfluss der auf dem Wägegut vorhandenen elektrostatischen Ladungen auf dem Wägeergebnis abzuschätzen. Dies soll mit möglichst wenig Elektronik gelöst werden.

Diese Aufgabe wird mit den Merkmalen des unabhängigen Verfahrensanspruchs und des unabhängigen Vorrichtungsanspruchs gelöst.

Eine Waage ist erfindungsgemäss mit einer Kraftmesszelle und einem Lastaufnehmer zur Aufnahme eines zu wiegendem Wägeguts versehen. Das Verfahren zur Abschätzung des Einflusses von elektrostatischen Ladungen auf dem Wägegut auf das Wägeergebnis einer Waage besteht aus den folgenden Schritten:
- Während abwechselnd eine erste vordefinierte positive und eine zweite vordefinierte negative Spannung an einer ersten Elektrode angelegt werden, wobei die Elektrode in der Umgebung des Wägeguts angeordnet ist,
- die jeweilige auf die Kraftmesszelle wirkende Kraft gemessen wird und als erstes und beziehungsweise als zweites Messergebnis erfasst wird, und
- die Differenz zwischen dem ersten und dem zweiten Messergebnis die Grösse des Einflusses der elektrostatischen Ladungen auf dem Wägegut auf das Wägeergebnis ergibt, und
- die Differenz zwischen dem ersten und dem zweiten Messergebnis einen im Wesentlichen proportionalen Anteil der Kraft darstellt, die durch elektrostatische Ladungen auf dem Wägegut das Wägeergebnis verändert, und als Signal an eine Auswerteeinheit ausgegeben wird.

Das Verfahren wird typischerweise bei Analysen- und Mikrowaagen angewendet. Die Elektrode ist in der Umgebung des Wägeguts, d.h. sie ist nicht in Kontakt mit dem Wägegut und ist ein Teil der Waage. Durch die an die erste Elektrode angelegte vordefinierte positive Spannung entstehen positive Ladungen auf der Elektrode und somit eine Potentialdifferenz und ein elektrisches Feld zwischen dem Wägegut und der Elektrode. Aus dem elektrischen wird Feld eine Kraft zwischen dem Wägegut und der Elektrode induziert. Die Elektrode ist in Bezug zum Wägegut derart angeordnet, dass das elektrische Feld einen Einfluss auf das Wägeergebnis hat.

Ist das Wägegut positiv geladen, so stossen sich die gleichpolig geladenen Elektrode und Wägegut ab. Wenn das Wägegut hingegen negativ geladen ist, wirkt zwischen Wägegut und positiv geladener Elektrode eine Anziehungskraft. Die vertikale Komponente dieser Kraft addiert sich zur Gewichtskraft und ändert auf diese Art das Messergebnis.

Wenn die Elektrode unterhalb des Wägeguts angeordnet ist und das Wägegut von der Elektrode angezogen wird, so addiert sich die elektrostatische Kraft zur Gewichtskraft. Umgekehrt, wenn sich die Elektrode oberhalb des Wägeguts befindet und das Wägegut anzieht, wirkt die Differenz zwischen der Schwerkraft und dem absoluten Wert der elektrostatischen Kraft auf die Kraftmesszelle.

Dementsprechend kann aus der Polarität der angelegten Spannung, der Position der Elektrode in Bezug auf das Wägegut und des Vorzeichens (positiv oder negativ) der Änderung des Messergebnisses die Polarität der Ladungen auf dem Wägegut abgeleitet werden.

Die auf der Kraftmesszelle wirkende Kraft wird gemessen und als erstes Wägeergebnis gespeichert.

Darauffolgend wird an die Elektrode eine zweite vordefinierte negative Spannung angelegt. Infolge des Polaritätswechsels der Ladungen auf der Elektrode wird die elektrostatische Kraft in die gegenseitige Richtung wirken. Hat man mit der positiven Spannung eine Anziehungskraft zwischen Elektrode und Wägegut erzeugt, so wirkt mit negativer Spannung an der Elektrode eine abstossende Kraft, und umgekehrt. Dementsprechend wird das Wägeergebnis grösser oder kleiner.

Die auf der Kraftmesszelle wirkende Kraft wird gemessen und als zweites Wägeergebnis gespeichert.

Je grösser die Menge an elektrostatische Ladungen auf dem Wägegut ist, desto grösser ist die induzierte Kraft auf dem Wägegut und desto mehr weicht das Wägeergebnis von der Schwerkraft ab.

Je grösser die angelegte Spannung ist, desto stärker ändert sich das Wägeergebnis, wenn elektrostatische Ladungen auf dem Wägegut vorhanden sind. Das heisst, die Sensibilität des Messverfahrens wird so erhöht. Es ist möglich mit verschiedenen Spannungsniveaus zu arbeiten, die abhängig vom Wägegut, vom Material des Wägeguts oder von der Grösse des Wägeguts bestimmt werden. Es hat sich herausgestellt, dass eine Spannung von 50-100 V eine ausreichend hohe Sensibilität ergibt.

Die an die Elektrode angelegte Spannung kann fest oder variabel sein. Beispielsweise kann sie derart gesteuert werden dass sie beim ersten Puls steigt, bis ein Einfluss auf die Gewichtsmessung detektiert wird, und dass dieser Wert für die folgenden Pulse behalten wird. Damit die Differenz zwischen dem ersten und dem zweiten Messergebnis aussagekräftig ist, müssen die erste und die zweite vordefinierten Spannungen den gleichen absoluten Wert haben und eine entgegengesetzte Polarität haben. Die an die Elektroden angelegten Spannungen können beispielsweise durch ein symmetrisches rechteckförmiges oder sinusförmiges Signal erzeugt sein.

Da die Gewichtsänderungen mit der Kraftmesszelle erfasst werden, hängt die Sensibilität der Abschätzung auch von der Auflösung der Waage ab. Je empfindlicher die Waage ist, desto genauer wird die Messung der Gewichtsänderung beim Anlegen der Spannung an die Elektrode.

In einem nächsten Schritt wird die Differenz zwischen dem ersten und dem zweiten Messergebnis gerechnet und an einer Auswerteeinheit ausgegeben.

Die Differenz zwischen dem ersten und dem zweiten Messergebnis ergibt die Grösse des Einflusses der elektrostatischen Ladungen auf dem Wägegut auf das Wägeergebnis. Sie ist im Wesentlichen proportional zur Kraft, die durch elektrostatische Ladungen das Wägeergebnis verändert.

Da bei diesem Verfahren nicht das absolute Wägeergebnis relevant ist, sondern die Änderungen des Wägeergebnisses aussagekräftig sind, kann das in Anspruch 1 beschriebene Verfahren gerade nach dem Auflegen einer Probe während des Einschwingvorgangs der Waage erfolgen. So kann das Messergebnis schneller geliefert werden, ohne den Benutzer warten zu lassen.

Vorzugsweise wird das Verfahren automatisch nach der Detektion eines Gewichtswechsels auf der Waage durchgeführt. So kann davon ausgegangen werden, dass sich ein neues Wägegut mit unbekannter Menge an elektrostatischen Ladungen auf dem Lastaufnehmer befindet.

Weiterhin bevorzugt ist es, die durch das durchgeführte Verfahren verursachten Gewichtsänderungen auf der Anzeige der Waage nicht darzustellen, um Verwirrung des Benutzers der Waage zu meiden.

Die Frequenz der an die Elektrode angelegten Spannung kann unterschiedlich sein. Es hat sich herausgestellt, dass die Gewichtsänderungen der Kraftmesszelle mit einer Frequenz zwischen 2 und 10 Hz gut verfolgt werden können. Idealerweise ist die Übertragungsfunktion der Kraftmesszelle sehr schnell und die Pulse sind hinreichend lang, dass die Kraftmesszelle gerade noch Zeit hat, den Gewichtsänderungen zu folgen. Typischerweise wird die Gewichtsmessung mit der an der Elektrode angelegten Spannung synchronisiert.

Vorzugsweise wird zur Auswertung des Messsignals während der Durchführung des Verfahrens ein paralleler Filterpfad in der Signalverarbeitung eingesetzt, um Signale mit der Frequenz der Spannungsversorgung der Elektrode herauszufiltern. Idealerweise wird dafür die "Chopper"-Technik verwendet. Sie ermöglicht eine besonders störungsresistente Messung.

Ein Vorteil dieser Erfindung liegt darin, dass sie mit der üblichen Waagenelektronik gelöst werden kann, ohne zusätzliche Bauteile mit Ausnahme der Elektrodenspeisung, und ohne den Einsatz von zusätzlichen Sensoren. Dies bedeutet, dass keine zusätzliche Wärmequelle in der vorhandenen Waage hinzugefügt wird. Zusätzlich werden die Herstell-Kosten der Waage durch die Vorrichtung zur Bestimmung elektrostatischer Ladung nur geringfügig erhöht.

In einer Ausführungsform der Erfindung gibt das Vorzeichen der Differenz zwischen dem ersten und dem zweiten Messergebnis die Polarität der elektrostatischen Ladungen auf dem Wägegut an.

Zur weiteren Ausgestaltung der Erfindung gibt die Auswerteeinheit mindestens ein Auswertesignal an eine Anzeigeeinheit und/oder an einen lonisator aus.

Bevorzugt ist in einer Ausgestaltung der Erfindung, dass das mindestens eine Auswertesignal einen Polaritätswert und/oder einen Betragswert aufweist, wobei der

Betragswert proportional zum Betrag der Differenz zwischen dem ersten und dem zweiten Messergebnis ist.

In einer weiteren Ausführungsform enthält das mindestens eine Auswertesignal eine Anweisung über die zu ergreifenden Massnahmen zur Entladung und/oder zur Abschirmung des Wägeguts.

Weiterhin bevorzugt wird in der Ausgestaltung des erfindungsgemäßen Verfahrens, dass das Wägeergebnis mit einem vordefinierten Korrekturfaktor und der Differenz zwischen dem ersten und dem zweiten Messergebnis korrigiert wird.

Der Vorteil, die Polarität der elektrostatischen Ladungen auf dem Wägegut zu kennen, ermöglicht dem Benutzer gezielte Massnahmen zur Beseitigung der Ladungen auf dem Wägegut zu ergreifen. Beispielsweise kann der Benutzer die Polarität der Ladungen auf dem Wägegut auf einer Anzeige entnehmen und mittels eines lonisators das Wägegut mit Ionen der gegengesetzten Polarität besprühen. Der lonisator kann in der Waage oder ausserhalb der Waage angeordnet sein. Vorteilhaft ist es den lonisator durch die Auswerteeinheit zu steuern.

Der Betrag der Differenz zwischen dem ersten und dem zweiten Messergebnis kann dazu verwendet werden, die Intensität und die Dauer der Deionisierung dementsprechend zu steuern. Der Bezug zwischen der Differenz zwischen dem ersten und dem zweiten Messergebnis und der Intensität und der Dauer der Deionisierung kann empirisch ermittelt werden.

Vorteilhaft ist es, die Position, die Dimension, das Material und die Form des Wägeguts über eine Messreihe konstant zu halten. Auf diese Art wird mit ähnlichen Messbedingungen gewogen. Dies ermöglicht den Einfluss der Ladungen auf dem Wägegut genauer einzuschätzen, und durch ein empirisches Vorgehen eine Kompensation des Messfehlers vorzunehmen.

Vorzugsweise wird das Wägeergebnis auf der Anzeigeeinheit ausgeblendet während der Durchführung des Verfahrens. So wird der Benutzer der Waage durch die wechselnde Anzeige nicht irritiert. Zudem ist von Vorteil, wenn erst nach der Durchführung des Verfahrens, die Anzeigeeinheit das Wägeergebnis anzeigt.

Eine weitere Ausführungsform sieht vor, dass ein Statussignal ausgegeben wird, wobei das Statussignal den Status des Verfahrens enthält und das Verfahren mindestens einen ersten Status "Verfahren nach Anspruch 1 wird durchgeführt" und einen zweiten Status "Verfahren nach Anspruch 1 abgeschlossen" aufweist.

Diese Funktion bringt dem Benutzer den Vorteil, über die Aktivität der Waage und über die Aussage der Anzeigeeinheit informiert zu sein. So wird er das Wägeergebnis während der Durchführung des Verfahrens nach Anspruch 1 nicht berücksichtigen. Wenn das Verfahren durchgeführt wurde, kann der Benutzer dank dem Statussignal entweder die Waage normal weiter betreiben, oder etwas unternehmen, um die Ladungen zu entfernen.

Vorzugsweise ist ein feststehendes Element der Waage in der Umgebung des Wägeguts und des Lastaufnehmers angeordnet, wobei dieses Element die erste Elektrode bildet. Beispielsweise ist das festehende Element der Wägeraumboden, das Windschutzdach oder eine Windschutzwand.

In einer weiteren Ausführungsform weist die Waage eine erste Elektrode und mindestens eine zweite Elektrode auf, und jede Elektrode ist im Wesentlichen eben.

Insbesondere wenn die erste Elektrode unterhalb des Wägeguts und die zweite Elektrode oberhalb des Wägeguts angeordnet sind, und die beiden Elektroden mit entgegengesetzten Spannungen geladen sind, wird die Sensibilität des Verfahren erhöht.

Besonders vorteilhaft ist es eine Waage derart auszustatten, dass die erste oder die zweite Elektrode unterhalb des Wägeguts und des Lastaufnehmers angeordnet ist. Durch die geringe Distanz zwischen Wägegut und Elektrode entstehen so in der Regel die grössten Kräfte und somit die grösste Sensitivität des Messverfahrens.

In einer bevorzugten Ausgestaltung weist die Elektrode unterhalb des Wägeguts und des Lastaufnehmers eine Aussparung in der Form der lotrechten Projektion des Lastträgers auf dem Wägeraumboden auf. Die Aussparung dient dazu, möglichst nur die elektrostatische Ladungen auf dem Wägegut in die Messung einzubeziehen, und kein elektrisches Feld, beziehungsweise keine elektrostatische Kraft zwischen dem geerdetem Lastaufnehmer und der Elektrode zu erzeugen.

Vorzugsweise ist die erste Elektrode im Wesentlichen senkrecht zur Schwerkraftrichtung angeordnet, und die mindestens zweite Elektrode ist im Wesentlichen senkrecht zur Schwerkraftrichtung oder in Schwerkraftrichtung angeordnet.

Vorteilhaft ist es, wenn die Waage einen Wägeraumboden und/oder ein Windschutzdach und/oder Windschutzwände aufweist, und diese oder Teile davon, als erste beziehungsweise als mindestens zweite Elektrode verwendet wird. Auf diese Art braucht das Verfahren als einzige zusätzliche Einrichtung eine steuerbare Elektrodenspeisung.

Die vorgenannten sowie beanspruchten und in den Ausführungsbeispielen beschriebenen erfindungsgemäß zu verwendenden Bauteile unterliegen in ihrer Größe, Form, Gestaltung, Materialauswahl und technischen Konzeptionen keinen besonderen Ausnahmebedingungen, so dass die in dem Anwendungsgebiet bekannten Auswahlkriterien uneingeschränkt Anwendung finden können.

Weitere Einzelheiten, Merkmale und Vorteile des Gegenstandes der Erfindung ergeben sich aus den Unteransprüchen sowie aus der nachfolgenden Beschreibung der zugehörigen Zeichnungen, in der - beispielhaft - ein bevorzugtes Ausführungsbeispiel der Erfindung dargestellt ist. In der Zeichnung zeigt:
- Fig. 1: eine Seitenansicht einer Waage mit Windschutz mit einem elektrostatisch geladenen Wägegut;
- Fig. 2: eine schematisierte Seitenansicht einer Waage mit einer Elektrode auf dem Wägeraumboden;
- Fig. 3: 3A eine Grafik der an der Elektrode angelegten Spannung in Funktion der Zeit;

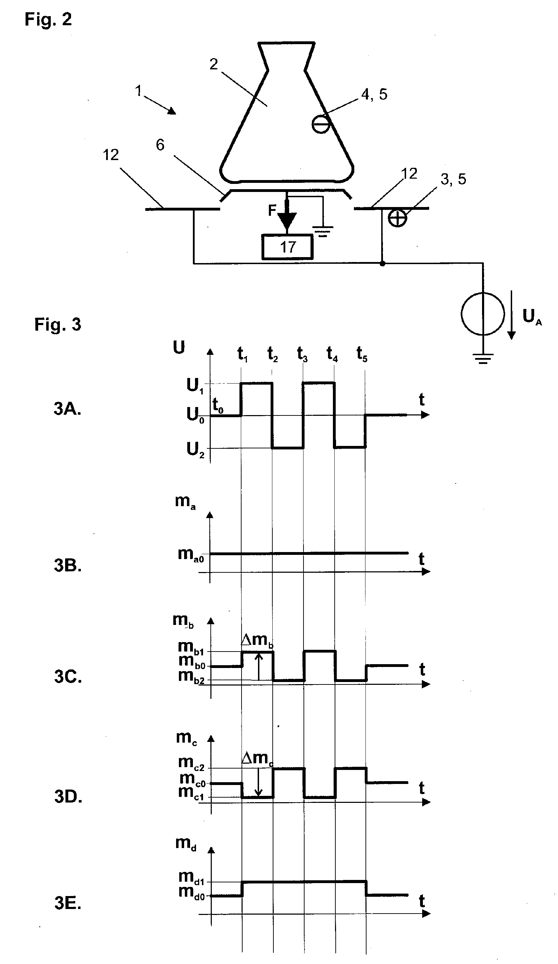

- Fig. 3: 3B, 3C, 3D und 3E das erhaltene Messergebnis beim Wiegen eines Wägeguts, das (3B) elektrostatisch nicht geladen und nicht leitend mit der Erde verbunden ist, (3C) negativ, (3D) positiv geladen ist, und (3E) leitend mit der Erde verbunden ist;

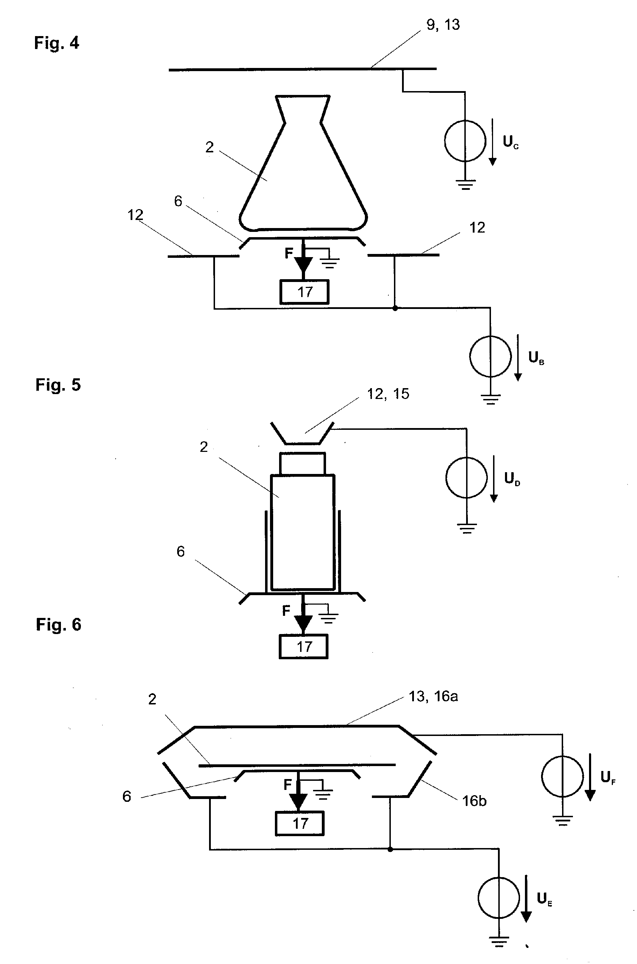

- Fig. 4: eine Seitenansicht einer Waage mit einem Wägeraumboden als erste Elektrode und einem Windschutzdach als zweite Elektrode;
- Fig. 5: eine Seitenansicht eines Dosiergeräts mit einem Dosierkopf als erste Elektrode; und
- Fig. 6: eine Seitenansicht einer Waage mit Filter und Filterbehälter wobei der untere Teil des Filterbehälters als erste Elektrode und der obere Teil des Filterbehälters als zweite Elektrode verwendet wird.

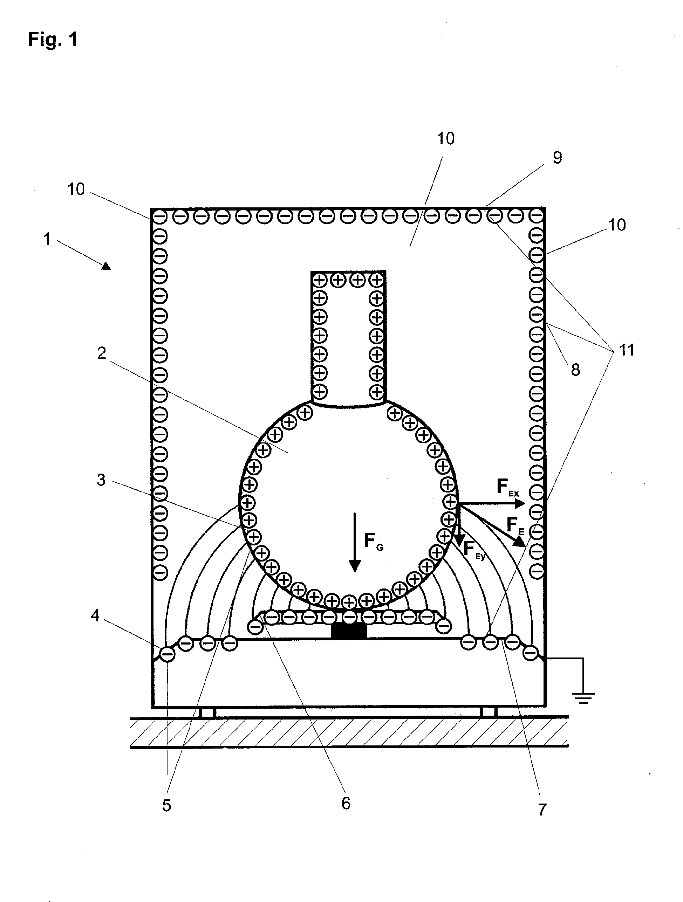

Figur 1 zeigt eine Waage 1 mit einem Windschutz 8. Ein Wägegut 2 liegt auf dem Lastaufnehmer 6. Das Wägegut 2 ist elektrostatisch positiv aufgeladen, das heisst dass die Oberfläche des Wägeguts 2 einen Elektronenmangel aufweist. Die Umgebung des Wägeguts 2, d.h. der Lastaufnehmer 6, der Wägeraumboden 7, die Windschutzwände 10 sowie das Windschutzdach 9 sind oberflächlich durch Influenz elektrostatisch negativ polarisiert. Sie haben einen Elektronenüberschuss an ihrer Oberfläche.

Elektronenüberschüsse und Elektronenmangeln sind das Resultat eines Elektronenaustauschs zwischen Atomen aus zwei Gegenständen die aus nichtleitfähigen Materialen bestehen. Der Elektronaustausch erfolgt typischerweise durch die gegenseitige Reibung der beiden Gegenstände. Dementsprechend bewirkt die Handhabung eines Wägeguts 2 bzw. Waagenteilen durch einen nicht geerdeten Mensch und/oder durch nicht geerdete Werkzeuge elektrostatische Ladungen 3, 5 auf dem Wägegut 2 bzw. auf nicht geerdeten Waagenteilen. Der Umfang des Elektronaustauschs hängt von den Materialen und von der Art wie diese in Berührung kommen ab.

Überschüssige Elektronen neigen dazu, den Platz von mangelnden Elektronen in einem anderen Atom einzunehmen. Diese Anziehung bildet ein elektrostatisches Feld zwischen Ladungen 3, 5 auf dem Wägegut 2 und den Ladungen 4,5 auf Waagenteilen. Das elektrostatische Feld induziert ein Kraftfeld F_{E}. Die vertikale Komponente F_{EY} der Kraft F_{E} addiert sich zur Schwerkraft des Wägeguts 2 F_{G} und beeinflusst somit das Wägeergebnis.

Figur 2 zeigt ein Wägegut 2 auf einem Lastaufnehmer 6. Der Lastaufnehmer 6 ist mit der Kraftmesszelle 17 gekoppelt.

Das Wägegut 2 ist elektrostatisch negativ geladen. Der Lastaufnehmer 6 ist geerdet. Bei einem nicht leitfähigen Wägegut 2 erfolgt keine Entladung durch die Erdung. Das geladene Wägegut 2 bleibt geladen.

Eine Elektrode 12 bildet den Wägeraumboden 7. Eine Aussparung in der lotrechten Projektion des Lastaufnehmers 6 ist ersichtlich. Die Elektrode 12 ist an eine Gleichspannungsquelle U_{A} angeschlossen. Wenn eine positive Gleichspannung U₁ an die Elektrode 12 angelegt wird, fliessen positive Ladungen 3 zur Elektrode 12. Das negativ geladene Wägegut 2, die positive geladene Elektrode 12 und die Luft dazwischen wirken wie ein Kondensator. Das elektrostatische Feld verursacht eine Anziehungskraft zwischen dem Wägegut 2 und der Elektrode 12 die auf das Wägegut 2 als Kraft in die Richtung der Elektrode 12 wirkt. Die Kraftmesszelle 17 misst die Summe der vertikalen Komponente dieser Kraft und der Schwerkraft.

Figur 3A zeigt beispielhaft die Spannung U die zur Ausführung des beanspruchten Verfahrens an die Elektrode 12 in Funktion der Zeit angelegt wird. U₀ ist die Spannung die vor und nach der Durchführung des beanspruchten Verfahrens an die Elektrode gelegt wird, und beträgt 0 V. U₁ ist eine positive Gleichspannung und U₂ ist eine negative Gleichspannung. U₁ und U₂ haben den gleichen Absolutwert. Die Spannung U ändert sich in Funktion der Zeit zu den Zeitpunkten to, t₁, t₂, t₃, t₄, und t₅ folgenderweise:
t₀ ist ein Zeitpunkt vor der Durchführung des beanspruchten Verfahrens. Die Elektrode 12 ist an Masse gelegt, U = U₀ = 0 V.
t₁ ist der Zeitpunkt zu dem das beanspruchte Verfahren startet und die an die Elektrode 12 angelegte Spannung U den Wert der ersten vordefinierten positiven Spannung U₁ annimmt.
t₂ ist der Zeitpunkt zu dem die an die Elektrode 12 angelegte Spannung U vom Wert der ersten vordefinierten positiven Spannung U₁ zum Wert der zweiten vordefinierten negativen Spannung U₂ wechselt.
t₃ ist der Zeitpunkt zu dem die an die Elektrode 12 angelegte Spannung U vom Wert der zweiten vordefinierten negative Spannung U₂ zum Wert der ersten vordefinierten positiven Spannung U₁ wechselt.
t₄ ist der Zeitpunkt zu dem die an die Elektrode 12 angelegte Spannung U vom Wert der ersten vordefinierten positiven Spannung U₁ zum Wert der zweiten vordefinierten negativen Spannung U₂ zum zweiten Mal wechselt.
t₅ ist der Zeitpunkt zu dem das beanspruchten Verfahren durchgeführt worden ist und die an die Elektrode 12 angelegte Spannung U vom Wert der zweiten vordefinierten negative Spannung zum Wert U₀ wechselt (U₀ = 0 V).

Die Figuren 3B, 3C, 3D und 3E zeigen das erhaltene Messergebnis mₐ beziehungsweise m_{b}, m_{c} und m_{d} beim Wiegen eines Wägeguts 2 mit einer unter Spannung stehenden Elektrode 12 gemäss Figur 3A. Das Wägegut ist auf Figur 3B nicht geladen und nicht leitend mit Erde verbunden, auf Figur 3C negativ und auf Figur 3D positiv geladen und auf Figur 3E leitend mit der Erde verbunden.

mₐ₀, m_{b0}, m_{c0}, m_{d0} sind die Werte des Messergebnisses vor und nach der Durchführung des beanspruchten Verfahrens, wenn die Spannung U den Wert U₀ annimmt. mₐ₀, m_{b1}, m_{b2}, m_{c1}, m_{c2} und m_{d1} sind die Werte des Messergebnisses während der Durchführung des beanspruchten Verfahrens. m_{b1} und m_{c1} sind die Werte des Messergebnisses während die Spannung U den Wert U₁ annimmt und m_{b2} und m_{c2} sind die Werte des Messergebnisses während die Spannung U den Wert U₂ annimmt. Δm_{b} und Δm_{c} sind die Differenz zwischen dem ersten und dem zweiten Messergebnis m_{b1} und m_{b2}, beziehungsweise m_{c1} und m_{c2}.

Beschreibung der Figuren 3A, 3B, 3C 3D und 3E in Funktion der Zeit. Die Beschreibungen basieren auf einer Einrichtung gemäss Figur 2, wo die Elektrode 12 unterhalb des Wägeguts 2 angeordnet ist:
Zeitraum t₀-t₁:
   3A. Die Elektrode 12 ist an Masse gelegt.
   3B. Das Wägegut 2 ist elektrostatisch nicht geladen und nicht leitend mit der Erde verbunden. Die Elektrode 12 ist geerdet, d.h. es gibt weder elektrostatisches Feld noch elektrostatische Kräfte. Die Kraftmesszelle 17 misst die echte Masse mₐ₀ des Wägeguts 2.
   3C. Das Wägegut 2 ist negativ geladen und die Elektrode 12 ist geerdet. Das negativ geladene Wägegut wird durch die elektrostatischen Anziehungskräfte zur Elektrode 12 hin gezogen. Das von der Kraftmesszelle 17 gemessene Messergebnis m_{b0} ist die Summe der effektiven Gewichtskraft des Wägeguts 2 und der vertikalen Komponente der Kraft, die das Wägegut in Richtung der Elektrode 12 zieht. Das gemessene Wägeergebnis ist grösser als die effektive Gewichtskraft des Wägeguts 2.
   3D. Das Wägegut 2 ist positiv geladen und die Elektrode 12 ist geerdet. Das positiv geladene Wägegut 2 wird durch die elektrostatischen Anziehungskräfte zur Elektrode 12 hin gezogen. Das von der Kraftmesszelle 17 gemessene Messergebnis m_{c0} ist die Summe der effektiven Gewichtskraft des Wägeguts 2 und der vertikalen Komponente der Kraft, die das Wägegut 2 in Richtung der Elektrode 12 zieht. Das gemessene Wägeergebnis ist grösser als die effektive Gewichtskraft des Wägeguts 2.
   3E. Das Wägegut 2 und die Elektrode 12 sind geerdet, d.h. es gibt weder elektrostatisches Feld noch elektrostatische Kräfte. Die Kraftmesszelle 17 misst die echte Masse m_{d0} des Wägeguts 2.
Zeitraum t₁-t₂:
   3A. Eine positive Gleichspannung U₁ wird an die Elektrode 12 angelegt.
   3B. Das Wägegut 2 ist nicht geladen und nicht geerdet. Die Elektrode 12 ist elektrostatisch positiv geladen. Es gibt dazwischen weder ein elektrostatisches Feld noch elektrostatische Kräfte. Die Kraftmesszelle 17 misst die echte Masse mₐ₀ des Wägeguts 2.
   3C. Das Wägegut 2 ist negativ geladen und die Elektrode 12 ist elektrostatisch positiv geladen. Der Potentialunterschied zwischen dem Wägegut 2 und der Elektrode 12 ist zum Zeitpunkt t₁ gegenüber dem Zeitraum t₀-t₁ gestiegen. Das heisst, dass sich die Anziehungskraft zwischen Wägegut 2 und Elektrode 12 gegenüber der Anziehungskraft im Zeitraum t₀-t₁ erhöht. Das Messergebnis m_{b1} ist grösser als die effektive Masse des Wägeguts 2 und grösser als im Zeitraum t₀-t₁.
   3D. Sowohl das Wägegut 2 als auch die Elektrode 12 sind positiv geladen. Dadurch stossen sich Wägegut 2 und Elektrode 12 ab. Das Messergebnis m_{c1} ist kleiner als die effektive Gewichtskraft des Wägeguts 2 und kleiner als im Zeitraum t₀-t₁.
   3E. Das Wägegut 2 ist geerdet und die Elektrode 12 ist elektrostatisch positiv geladen. Das geerdete Wägegut unterliegt die Wirkung der Influenz. Obwohl das Wägegut 2 ungeladen ist, wird es durch die elektrostatischen Anziehungskräfte zur geladenen Elektrode 12 hin gezogen. Das Messergebnis m_{d1} ist grösser als die effektive Masse des Wägeguts 2.
Zeitraum t₂-t₃:
   3A. Eine negative Gleichspannung U₂ wird an die Elektrode 12 angelegt. Die Elektrode 12 wird dementsprechend elektrostatisch negativ geladen.
   3B. Das Wägegut 2 ist nicht geladen und nicht mit der Erde leitend verbunden. Die Elektrode 12 ist elektrostatisch negativ geladen. Es gibt dazwischen weder ein elektrostatisches Feld noch elektrostatische Kräfte. Die Kraftmesszelle 17 misst die echte Masse mₐ₀ des Wägeguts 2.
   3C. Sowohl das Wägegut 2 als auch die Elektrode 12 sind elektrostatisch negativ geladen. Die Richtung der elektrostatischen Kraft hat sich geändert. Wägegut 2 und Elektrode 12 stossen sich ab. Das Messergebnis m_{b2} ist dementsprechend kleiner als die effektive Masse des Wägeguts 2 und kleiner als im Zeitraum t₀-t₁.
   3D. Das Wägegut 2 ist elektrostatisch positiv geladen und die Elektrode 12 ist negativ geladen. Der Potentialunterschied ist zum Zeitpunkt t₂ gegenüber dem Zeitraum t₀-t₁ gestiegen. Das heisst, dass sich die Anziehungskraft zwischen Wägegut 2 und Elektrode 12 gegenüber der Anziehungskraft im Zeitraum t₀-t₁ erhöht. Das Messergebnis m_{c2} ist grösser als die effektive Masse des Wägeguts 2 und grösser als im Zeitraum t₀-t₁.
   3E. Das Wägegut 2 ist geerdet und die Elektrode 12 ist elektrostatisch negativ geladen. Obwohl das Wägegut 2 ungeladen ist, wird es durch die elektrostatischen Anziehungskräfte zur geladenen Elektrode 12 hin gezogen. Wenn die Spannungen U₁ und U₂ die gleichen Absolutwerte aufweisen, verändert sich das Messergebnis m_{d1} gegenüber dem Zeitraum t₁-t₂ nicht.

Im Zeitraum t₃-t₄ erfolgt das gleiche wie im Zeitraum t₁-t₂.

Im Zeitraum t₄-t₅ erfolgt das gleiche wie Im Zeitraum t₂-t₃.

Das beanspruchte Verfahren wird auf Figur 3 zwei Mal nacheinander durchgeführt. Es kann aber auch nur einfach oder mehrfach durchgeführt worden.

Das Messergebnis kann durch externe Störungen beeinträchtigt sein. Wiederholungen des Verfahrens und Signalverarbeitung der entsprechenden Messergebnisse ermöglichen eine Reduktion der Streuung der Messergebnisse bzw. eine Reduktion des Einflusses von Störungen auf die Messung des Einflusses der elektrostatischen Ladungen. Diese Technik ist allgemein bekannt unter den Begriffen "Chopper-Technik" oder "Lock-in Verstärker"

Auf der Figur 3 wird das Verfahren zum Zeitpunkt t₅ beendet. Danach erfolgt das gleiche wie im Zeitraum t₀-t₁.

Das Messergebnis kann nach der Durchführung des beanspruchten Verfahrens mittels der entsprechenden Werte von Δm_{b} und Δm_{c} korrigiert werden.

Figur 4 zeigt eine Waage 1 mit einem Wägegut 2 auf dem Lastaufnehmer 6. Diese Ausführungsform weist zwei Elektroden 12, 13 auf. Der Lastaufnehmer 6 ist geerdet und mit der Kraftmesszelle 17 gekoppelt.

Die erste Elektrode 12 ist unterhalb des Lastaufnehmers 6 angeordnet und weist eine Aussparung in Form der lotrechten Projektion des Lastaufnehmers 6. Sie bildet den Wägeraumboden. Die Aussparung der Elektrode 12 dient dazu, unerwünschte elektrostatische Kräfte zwischen der Elektrode und dem geerdeten Lastaufnehmer 6 zu vermindern.

Es ist denkbar die Waage 1 mit einer ersten Elektrode 12 auszustatten, die nicht aus dem Wägeraumboden 7 gebildet ist, sondern ein zusätzlicher Teil der Waage 1 ist. Die erste Elektrode 12 kann flach sein, oder eine andere Form haben. Beispielsweise kann sie in Form einer das Wägegut 2 umgebende Schale sein. Sie kann die ganze Fläche des Wägebodens decken oder nur einen Teil davon. Die Aussparung kann in Form der lotrechten Projektion des Lastaufnehmers 6 oder kleiner oder grösser sein. Es wäre auch möglich die erste Elektrode 12 ohne Aussparung zu gestalten.

Eine zweite Elektrode 13, kann oberhalb des Wägeguts 2 angeordnet sein. Sie bildet das Windschutzdach 9.

Die obere Elektrode 13 kann flach sein oder eine andere Form haben. Sie kann ein Teil der Waage 1 sein. Sie kann auch die Form eines über dem Wägegut 2 angebrachten Deckels haben.

Die erste Elektrode 12 ist an einer ersten Gleichspannungsquelle U_{B} angeschlossen und die zweite Elektrode 13 ist an einer zweiten Gleichspannungsquelle U_{C} angeschlossen. Vorteilhaft ist es an die Elektroden 12, 13 Spannungen mit jeweils entgegengesetzter Polarität anzulegen.

Die Figur 5 zeigt ein Wägegut 2 in Form eines Behälters auf einer Waage 1 und einen Dosierkopf 15 zum Füllen des Behälters mit einer Substanz.

Der Dosierkopf 15 zum Dosieren einer Substanz in den Behälter ist über dem Wägegut 2 angeordnet und bildet die Elektrode 12. Er ist an einer Spannungsquelle U_{D} angeschlossen. Diese Ausführungsform ist vorteilhalft, weil durch die geringe Distanz zwischen Dosierkopf 15 und Behälteröffung (im Wägegut 2) hier die dominanten elektrostatischen Kräfte wirken.

Der Lastaufnehmer 6 ist derart gestaltet, dass er das Wägegut 2 in einer festen und konstanten Position aufnehmen kann. Der Lastaufnehmer 6 ist geerdet. Die konstante Position ermöglicht es wiederholt mit ähnlichen Messbedingungen in Bezug auf den Einfluss der Elektrostatik zu wiegen. Ein Vorteil der Wiederholbarkeit der Messbedingungen liegt darin, dass eine Kompensation der Messwertverfälschung durch elektrostatische Ladungen 5 auf dem Wägegut 2 empirisch bestimmt werden kann.

Figur 6 zeigt eine Waage 1 mit einem Partikelfilter als Wägegut 2 und einem Filterträger 16a, 16b. Der Filter liegt auf dem Lastaufnehmer 6, der mit der Kraftmesszelle 17 gekoppelt ist. Der Filterträger 16a, 16b besteht aus zwei Teilen 16a, 16b, einem oberen Teil 16a und einem unteren Teil 16b. Der untere Teil bildet die erste Elektrode 12 und der obere Teil bildet die zweite Elektrode 13. Beide Elektroden 12, 13 sind galvanisch getrennt. Die erste Elektrode 12 ist unterhalb des Filters angeordnet und ist an einer ersten Gleichspannungsquelle U_{E} angeschlossen. Die zweite Elektrode 13 ist oberhalb des Filters angeordnet und an einer zweiten Gleichspannungsquelle U_{F} angeschlossen.

Da Partikelfilter schlechte elektrische Leiter sind, sind sie besonders anfällig für elektrostatische Ladungen. Wegen der horizontalen Position der Fläche des Filters haben die Ladungen 5 des Filters einen erheblichen Einfluss auf das Wägeergebnis. Die Ladungen 5 auf dem Filter wirken in zwei gegengesetzten Richtungen, deshalb ist es von Vorteil den Filterträger bzw. die Elektroden 12, 13 in zwei Teilen zu gestalten, die den Filter überdecken bzw. unterdecken. Somit kann der grösste Teil des Einflusses der Ladungen 5 auf das Wägeergebnis gemessen werden.

Die vorliegende Erfindung ist besonders vorteilhaft sowohl für die Gewichtsmessung von Filtern als auch von anderen flachen Wägegütern.

### Bezugszeichenliste

- 1: Waage
- 2: Wägegut
- 3: Elektrostatische Ladungen positiver Polarität
- 4: Elektrostatische Ladungen negativer Polarität
- 5: Elektrostatische Ladungen
- 6: Lastaufnehmer
- 7: Wägeraumboden
- 8: Windschutz
- 9: Windschutzdach
- 10: Windschutzwand
- 11: Umgebungsteil
- 12: Erste Elektrode
- 13: Zweite Elektrode
- 14:
- 15: Dosierungskopf
- 16, 16a,16b: Filterbehälter (oberer Teil (16a) und unterer Teil (16b))
- 17: Kraftmesszelle
- U_{A}, U_{B}, U_{D}, U_{E}: Erste schaltbare Gleichspannungsquelle
- U_{C}, U_{F}: Zweite schaltbare Gleichspannungsquelle
- mₐ: Messergebnis bei nicht geladenem und nicht geerdetem Wägegut
- m_{b}: Messergebnis bei positiv geladenem Wägegut
- m_{c}: Messergebnis bei negativ geladenem Wägegut
- m_{d}: Messergebnis bei geerdetem Wägegut
- F: Auf die Kraftmesszelle wirkende Kraft
- U₁: Erste vordefinierte positive Spannung
- U₂: Zweite vordefinierte negative Spannung
- mₐ₀, m_{b0,} m_{c0}, m_{d0}: Messergebnis vor und nach der Durchführung des Verfahrens
- mₐ₀, m_{d1}: Messergebnis während der Durchführung des Verfahrens
- m_{b1}, m_{c1}: Erstes Messergebnis
- m_{b2}, m_{c2}: Zweites Messergebnis
- Δm_{b}, Δm_{c}: Differenz zwischen erstem und zweitem Messergebnis

## Patentansprüche

1. Verfahren zur Abschätzung des Einflusses von elektrostatischen Ladungen (5) des Wägeguts (2) auf das Wägeergebnis einer Waage (1), welche Waage (1) eine Kraftmesszelle (17) und einen Lastaufnehmer (6) zur Aufnahme eines zu wiegenden Wägeguts (2) aufweist, **dadurch gekennzeichnet, dass**
a) während abwechselnd eine erste vordefinierte positive (U₁) und eine zweite vordefinierte negative Spannung (U₂) an einer ersten Elektrode (12) angelegt werden, wobei die Elektrode (12) in der Umgebung des Wägeguts (2) angeordnet ist,
b) die jeweilige auf die Kraftmesszelle (17) wirkende Kraft gemessen wird und als erstes (m_{b1}, m_{c1}) und beziehungsweise als zweites Messergebnis (m_{b2}, m_{c2}) erfasst wird, und
c) die Differenz (Δm_{b}, Δm_{c}) zwischen dem ersten (m_{b1}, m_{c1}) und dem zweiten (m_{b2}, m_{c2}) Messergebnis die Grösse des Einflusses der elektrostatischen Ladungen (5) auf dem Wägegut (2) auf das Wägeergebnis ergibt, und
d) die Differenz (Δm_{b}, Δm_{c}) zwischen dem ersten (m_{b1}, m_{c1}) und dem zweiten (m_{b2}, m_{c2}) Messergebnis einen im Wesentlichen proportionalen Anteil der Kraft darstellt, die durch elektrostatische Ladungen (5) auf dem Wägegut (2), das Wägeergebnis verändert, und als Signal an eine Auswerteeinheit ausgegeben wird.

2. Verfahren nach Anspruch 1, **dadurch gekennzeichnet, dass** das Vorzeichen der Differenz (Δm_{b}, Δm_{c}) zwischen dem ersten (m_{b1}, m_{c1}) und dem zweiten Messergebnis (m_{b2}, m_{c2}) die Polarität der elektrostatischen Ladungen (5) auf dem Wägegut (2) angibt.

3. Verfahren nach Anspruch 1 oder 2, **dadurch gekennzeichnet, dass** die Auswerteeinheit mindestens ein Auswertesignal an eine Anzeigeeinheit und/oder an ein Ionisationsgerät ausgibt.

4. Verfahren nach Anspruch 3, **dadurch gekennzeichnet, dass** das mindestens eine Auswertesignal einen Polaritätswert und /oder einen Betragswert aufweist, wobei der Betragswert proportional zum Betrag der Differenz (Δm_{b}, Δm_{c}) zwischen dem ersten (m_{b1}, m_{c1}) und dem zweiten Messergebnis (m_{b2}, m_{c2}) ist.

5. Verfahren nach Anspruch 4, **dadurch gekennzeichnet, dass** das mindestens eine Auswertesignal eine Anweisung über die zu ergreifenden Massnahmen zur Entladung und/oder zur Abschirmung des Wägeguts (2) enthält.

6. Verfahren nach einem der Ansprüche 1 bis 5, **dadurch gekennzeichnet, dass** das Wägeergebnis mit einem vordefinierten Korrekturfaktor und der Differenz (Δm_{b}, Δm_{c}) zwischen dem ersten (m_{b1}, m_{c1}) und dem zweiten Messergebnis (m_{b2}, m_{c2}) korrigiert wird.

7. Verfahren nach einem der Ansprüche 1 bis 6, **dadurch gekennzeichnet, dass** die Position, die Dimension, das Material und die Form des Wägeguts (2) über eine Messreihe konstant gehalten werden.

8. Verfahren nach einem der Ansprüche 3 bis 7, **dadurch gekennzeichnet, dass** während es durchgeführt wird, das Wägeergebnis auf der Anzeigeeinheit ausgeblendet wird und nachdem es durchgeführt wurde, das Wägeergebnis auf der Anzeigeeinheit angezeigt wird.

9. Verfahren nach einem der Ansprüche 3 bis 8, **dadurch gekennzeichnet, dass** ein Statussignal ausgegeben wird, wobei das Statussignal den Status des Verfahrens enthält und das Verfahren mindestens einen ersten Status "Verfahren nach Anspruch 1 wird durchgeführt" und einen zweiten Status "Verfahren nach Anspruch 1 abgeschlossen" aufweist.

10. Vorrichtung zur Durchführung des Verfahrens nach Anspruch 1, **dadurch gekennzeichnet, dass** ein feststehendes Element der Waage (1) in der Umgebung des Wägeguts (2) und des Lastaufnehmers (6) angeordnet ist, wobei dieses Element die erste Elektrode (12) bildet.

11. Vorrichtung nach Anspruch 10, **dadurch gekennzeichnet, dass** sie eine erste Elektrode (12) und mindestens eine zweite Elektrode (13) aufweist, und dass jede Elektrode (12, 13) im Wesentlichen eben ist.

12. Vorrichtung nach einem der Ansprüche 10 oder 11, **dadurch gekennzeichnet, dass** die erste oder die zweite Elektrode (12, 13) unterhalb des Wägeguts (2) und des Lastaufnehmers (6) angeordnet ist.

13. Vorrichtung nach Anspruch 12, **dadurch gekennzeichnet, dass** die Elektrode (12, 13) unterhalb des Wägeguts (2) und des Lastaufnehmers (6) eine Aussparung in der Form der lotrechten Projektion des Lastaufnehmers (6) auf dem Wägeraumboden (7) aufweist.

14. Vorrichtung nach einem der Ansprüche 10 bis 13, **dadurch gekennzeichnet, dass** die erste Elektrode (12) im Wesentlichen senkrecht zur Schwerkraftrichtung angeordnet ist, und dass die zweite Elektrode (13) im Wesentlichen senkrecht zur Schwerkraftrichtung oder in Schwerkraftrichtung angeordnet ist.

15. Vorrichtung nach einem der Ansprüche 10 bis 14, **dadurch gekennzeichnet, dass** die Waage (1) einen Wägeraumboden (7) und/oder ein Windschutzdach (9) und/oder Windschutzwände (10) aufweist, und diese oder Teile davon, als erste beziehungsweise und/oder als zweite Elektrode (12, 13) verwendbar sind.

## Claims

1. Method of estimating the effect that electrostatic charges (5) residing on the weighing object (2) have on the weighing result of a balance (1), said balance (1) comprising a force-measuring cell (17) and a load receiver (6) on which to place the object (2) that is to be weighed, wherein the method is **characterized in that**:
a) while a first predefined positive voltage (U₁) and a second predefined negative voltage (U₂) are alternatingly applied to a first electrode (12) which is arranged in the vicinity of the weighing object (2);
b) the forces acting on the force-measuring cell (17), respectively, during application of said first voltage (U₁) and during application of said second voltage (U₂) are measured and said measurements are registered as the first measurement result (m_{b1}, m_{c1}) and the second measurement result (m_{b2}, m_{c2}); wherein
c) the difference (Δmb, Δmc) between the first measurement result (m_{b1}, m_{c1}) and the second measurement result (m_{b2}, mc₂) represents the magnitude of the influence that the electrostatic charges (5) residing on the weighing object (2) are having on the weighing result; and
d) the difference (Δmb, Δmc) between the first measurement result (m_{b1}, m_{c1}) and the second measurement result (m_{b2}, mc₂) represents an essentially proportional part of the force resulting from electrostatic charges (5) residing on the weighing object (2), which causes a change in the weighing result and is sent as a signal to a processor unit.

2. Method according to claim 1, **characterized in that** the algebraic sign of the difference (Δm_{b}, Δm_{c}) between the first measurement result (m_{b1}, m_{c1}) and the second measurement result (m_{b2}, mc₂) indicates the polarity of the electrostatic charges (5) residing on the weighing object (2).

3. Method according to claim 1 or 2, **characterized in that** the processor unit sends at least one output signal to an indicator unit and/or an ionizer.

4. Method according to claim 3, **characterized in that** the at least one output signal from the processor includes a polarity value and/or a value of an absolute magnitude, wherein the value for the absolute magnitude is proportional to the amount of the difference (Δm_{b}, Δm_{c}) between the first measurement result (m_{b1}, m_{c1}) and the second measurement result (m_{b2}, m_{c2}).

5. Method according to claim 4, **characterized in that** the at least one output signal includes information about the measures to be taken to drain off the charge and/or to screen the weighing object (2).

6. Method according to one of the claims 1 to 5, **characterized in that** the weighing result is corrected with a predefined correction factor and the difference (Δmb, Δm_{c}) between the first measurement result (m_{b1}, m_{c1}) and the second measurement result (m_{b2}, m_{c2}).

7. Method according to one of the claims 1 to 6, **characterized in that** the position, the dimension, the material and the shape of the weighing object (2) are held constant over the course of a measurement series.

8. Method according to one of the claims 3 to 7, **characterized in that** the weighing result is not displayed on the indicator unit during the time period when the method is being performed and that the weighing result is displayed on the indicator unit after the method has been performed.

9. Method according to one of the claims 3 to 8, **characterized in that** a status signal is delivered, wherein said status signal indicates a current status of the method, differentiating at least between a first status "method according to claim 1 in process" and a second status "method according to claim 1 completed".

10. Apparatus for carrying out the method of claim 1, **characterized in that** a fixed element of the balance (1) is arranged in the vicinity of the weighing object (2) and of the load receiver (6), wherein said fixed element forms the first electrode.

11. Apparatus according to claim 10, **characterized in that** the apparatus comprises a first electrode (12) and at least a second electrode (13), and that each of the electrodes (12, 13) is of an essentially flat, planar shape.

12. Apparatus according to claim 10 or 11, **characterized in that** the first electrode (12) or the second electrode (13) is arranged below the weighing object (2) and the load receiver (6).

13. Apparatus according to claim 12, **characterized in that** the electrode (12, 13) below the weighing object (2) and below the load receiver (6) has a cutout with the contour shape of the vertical projection of the load receiver (6) onto the weighing compartment floor (7).

14. Apparatus according to one of the claims 10 to 13, **characterized in that** the first electrode (12) is oriented essentially orthogonal to the direction of gravity and the second electrode (13) is oriented either essentially orthogonal to the direction of gravity or in the direction of gravity.

15. Apparatus according to one of the claims 10 to 14, **characterized in that** the balance (1) has a weighing compartment floor (7) and/or a draft shield roof (9) and/or draft shield walls (10), and that said weighing compartment floor (7), and/or said draft shield roof (9) and/or said draft shield walls (10) can be used either in their entirety or in part as the first and/or the second electrode (12, 13).

## Revendications

1. Procédé pour l'évaluation de l'influence des charges électrostatiques (5) de l'objet à peser (2) sur le résultat de pesée d'une balance (1), ladite balance (1) comportant une cellule de pesage (17) et un récepteur de charge (6) destiné à recevoir un objet à peser (2), **caractérisé en ce que**
a) pendant qu'une première tension positive (U₁) prédéfinie et une deuxième tension négative (U₂) prédéfinie sont appliquées en alternance à une première électrode (12), l'électrode (12) étant agencée dans l'environnement de l'objet à peser (2),
b) la force correspondante agissant sur la cellule de pesage (17) est mesurée et enregistrée comme premier (m_{b1}, m_{c1}) et respectivement comme deuxième résultat de pesée (m_{b2}, m_{c2}), et
c) la différence (Δm_{b}, Δm_{c}) entre le premier (m_{b1}, m_{c1}) et le deuxième résultat de pesée (m_{b2}, m_{c2}) représente la grandeur de l'influence des charges électrostatiques (5) sur l'objet à peser (2) sur le résultat de pesée, et
d) la différence (Δm_{b}, Δm_{c}) entre le premier (m_{b1}, m_{c1}) et le deuxième résultat de pesée (m_{b2}, m_{c2}) représente une part proportionnelle substantielle de la force modifiant le résultat de pesée par des charges électrostatiques (5) sur l'objet à peser (2), et est transmise à une unité d'évaluation en tant que signal.

2. Procédé selon la revendication 1, **caractérisé en ce que** le signe de la différence (Δm_{b}, Δm_{c}) entre le premier (m_{b1}, m_{c1}) et le deuxième résultat de pesée (m_{b2}, m_{c2}) indique la polarité des charges électrostatiques (5) sur l'objet à peser (2).

3. Procédé selon la revendication 1 ou 2, **caractérisé en ce que** l'unité d'évaluation transmet au moins un signal d'évaluation à une unité d'affichage et/ou à un appareil d'ionisation.

4. Procédé selon la revendication 3, **caractérisé en ce que** l'au moins un signal d'évaluation comporte une valeur de polarité et/ou une valeur de montant, la valeur de montant étant proportionnelle au montant de la différence (Δm_{b}, Δm_{c}) entre le premier (m_{b1}, m_{c1}) et le deuxième résultat de pesée (m_{b2}, m_{c2}).

5. Procédé selon la revendication 4, **caractérisé en ce que** l'au moins un signal d'évaluation contient une instruction concernant les mesures à prendre pour le déchargement électrostatique et/ou le blindage de l'objet à peser (2).

6. Procédé selon l'une des revendications 1 à 5, **caractérisé en ce que** le résultat de pesée est corrigé avec un facteur de correction prédéfini et avec la différence (Δm_{b}, Δm_{c}) entre le premier (m_{b1}, m_{c1}) et le deuxième résultat de pesée (m_{b2}, mc₂).

7. Procédé selon l'une des revendications 1 à 6, **caractérisé en ce que** la position, la dimension, le matériau et la forme de l'objet à peser (2) sont maintenus constants sur une série de mesures.

8. Procédé selon l'une des revendications 3 à 7, **caractérisé en ce que** pendant l'exécution de celui-ci, le résultat de pesée est masqué sur l'unité d'affichage, et après l'exécution, le résultat de pesée est affiché sur l'unité d'affichage.

9. Procédé selon l'une des revendications 3 à 8, **caractérisé en ce qu'**un signal d'état est émis, le signal d'état contenant l'état du procédé, et le procédé présentant au moins un premier état « exécution du procédé selon la revendication 1 » et un deuxième état « fin du procédé selon la revendication 1 ».

10. Dispositif pour l'exécution du procédé selon la revendication 1, **caractérisé en ce qu'**un élément fixe de la balance (1) est agencé dans l'environnement de l'objet à peser (2) et du récepteur de charge (6), cet élément formant la première électrode (12).

11. Dispositif selon la revendication 10, **caractérisé en ce qu'**il comporte une première électrode (12) et au moins une deuxième électrode (13), et **en ce que** chaque électrode (12, 13) est essentiellement plane.

12. Dispositif selon l'une des revendications 10 ou 11, **caractérisé en ce que** la première ou la deuxième électrode (12, 13) est agencée sous l'objet à peser (2) et sous le récepteur de charge (6).

13. Dispositif selon la revendication 12, **caractérisé en ce que** l'électrode (12, 13) située sous l'objet à peser (2) et sous le récepteur de charge (6) présente un évidement sous la forme d'une projection verticale du récepteur de charge (6) sur le fond de l'espace de pesée (7).

14. Dispositif selon l'une des revendications 10 à 13, **caractérisé en ce que** la première électrode (12) est agencée essentiellement perpendiculairement à la direction de la pesanteur, et **en ce que** la deuxième électrode (13) est agencée essentiellement perpendiculairement à la direction de la force de pesanteur ou dans la direction de la force de pesanteur.

15. Dispositif selon l'une des revendications 10 à 14, **caractérisé en ce que** la balance (1) comporte un fond de l'espace de pesée (7) et/ou un toit de protection contre le vent (9) et/ou des parois de protection contre le vent (10), et ceux-ci ou des parties de ceux-ci pouvant être utilisés comme première et/ou éventuellement comme deuxième électrode (12, 13).
